# EUROPEAN PATENT APPLICATION

(11) **EP 4 827 270 A1**
(43) Date of publication of application: **21.10.2026**
(21) Application number: 24921418.0
(22) Date of filing: 06.09.2024
(51) Int. Cl.: H10D 30/47

(54) **SEMICONDUCTOR SWITCH COMPONENT, MANUFACTURING METHOD, WAFER, PACKAGING STRUCTURE, AND ELECTRONIC DEVICE**

(30) Priority: 31.01.2024 CN 202410146486
(71) Applicant: Huawei Technologies Co., Ltd., Shenzhen, Guangdong 518129 (CN)
(72) Inventor: REN, Yuan, Shenzhen, Guangdong 518129 (CN); LI, Shuiming, Shenzhen, Guangdong 518129 (CN); MA, Huimei, Shenzhen, Guangdong 518129 (CN); LUO, Ruihong, Shenzhen, Guangdong 518129 (CN); LU, Wei, Shenzhen, Guangdong 518129 (CN)
(74) Representative: Goddar, Heinz J.
(86) International application number: PCT/CN2024/117389
(87) International publication number: WO 2025/161393

(57) **Abstract**

Embodiments of this application provide a semiconductor switching device and a manufacturing method thereof, a wafer, a packaging structure, and an electronic device, and relate to the field of semiconductor technologies, to reduce an on resistance of a power switching device when a breakdown voltage requirement of the power switching device is met. The semiconductor switching device includes a substrate, a channel layer, a barrier layer, at least one transistor, and a regrowth semiconductor layer. The regrowth semiconductor layer is located in a first region in which one transistor or a plurality of transistors connected in parallel are disposed and a second region in which no transistor is disposed, and the regrowth semiconductor layer is disposed on a side, facing a gate, of the barrier layer. A part, located in the first region, of the regrowth semiconductor layer is used to reduce an on resistance, and a part, located in the second region, of the regrowth semiconductor layer is used to balance supply of a gas precursor in a thin film growth process, to implement a uniform material growth thickness and material composition ratio.

## Description

This application claims priority to Chinese Patent Application No. 202410146486.3, filed with the China National Intellectual Property Administration on January 31, 2024 and entitled "SEMICONDUCTOR SWITCHING DEVICE AND MANUFACTURING METHOD THEREOF, WAFER, PACKAGING STRUCTURE, AND ELECTRONIC DEVICE", which is incorporated herein by reference in its entirety.

### TECHNICAL FIELD

This application relates to the field of semiconductor technologies, and in particular, to a semiconductor switching device and a manufacturing method thereof, a wafer, a packaging structure, and an electronic device.

### BACKGROUND

With continuous development of power semiconductor devices, a power semiconductor device based on a conventional silicon-based material cannot meet product requirements such as high-voltage resistance, high-temperature resistance, high efficiency, and high frequency due to a narrow band gap of the power semiconductor device. Therefore, a power semiconductor with a wide band gap, for example, gallium nitride, gradually replaces the conventional silicon-based material. Based on this, when a power switching device is fabricated by using the power semiconductor with the wide band gap, to meet a design requirement for a high breakdown voltage of the power switching device, an on resistance per unit area of the power switching device is large, resulting in degradation of conduction performance of the power switching device.

### SUMMARY

This application provides a semiconductor switching device and a manufacturing method thereof, a wafer, a packaging structure, and an electronic device, to reduce an on resistance of a power switching device when a breakdown voltage requirement of the power switching device is met.

To achieve the foregoing objective, this application uses the following technical solutions.

According to one aspect of this application, a semiconductor switching device is provided. The semiconductor switching device has a second region and a first region, and the second region is disposed around the first region. In addition, the semiconductor switching device includes a substrate, a channel layer, a barrier layer, at least one transistor, and a regrowth semiconductor layer. The channel layer is disposed on the substrate. The barrier layer is disposed on a side, away from the substrate, of the channel layer. The at least one transistor is located in the first region, and a gate of the transistor is disposed on a side, away from the channel layer, of the barrier layer. The first region is a region in which one transistor or a plurality of transistors connected in parallel are disposed, and the second region is a region in which no transistor is disposed. The regrowth semiconductor layer is located in the first region and the second region, where the regrowth semiconductor layer is disposed on the side, facing the gate, of the barrier layer.

In this case, the channel layer and the barrier layer may form a heterojunction, and a polarization effect in the heterojunction may induce formation of a two-dimensional electron gas at an interface between the channel layer and the barrier layer. The regrowth semiconductor layer located in the first region may increase a concentration of the two-dimensional electron gas. Therefore, a current of the semiconductor switching device may be increased and an on resistance per unit area (Ron) of the semiconductor switching device may be reduced, thereby improving conduction performance of the semiconductor switching device. In addition, the regrowth semiconductor layer may further be located in the second region. In this way, when the regrowth semiconductor layer is formed, the first region and the second region may be exposed in an aperture region of a used mask material. Based on this, a part, falling into the first region through the aperture region of the mask material, of elements released by a gas precursor may form a part, located in the first region, of the regrowth semiconductor layer. In addition, a part, falling into the second region through the aperture region of the mask material, of the elements may form a part, located in the second region, of the regrowth semiconductor layer. In this way, supply of a gas precursor in a thin film growth process can be balanced, to implement a uniform material growth thickness and material composition ratio. In this way, a probability of occurrence of a phenomenon that an edge of the regrowth semiconductor layer in the first region is thick because an unconsumed element falls into an edge of the first region can be reduced, and uniformity of a thickness of the regrowth semiconductor layer in the first region can be improved.

In an optional implementation, a band gap of the regrowth semiconductor layer is greater than a band gap of the channel layer. Therefore, the regrowth semiconductor layer can enhance the polarization effect in the heterojunction formed between the barrier layer and the channel layer, and help increase the concentration of the two-dimensional electron gas.

In an optional implementation, the regrowth semiconductor layer includes a first regrowth layer and a second regrowth layer. The first regrowth layer is disposed in the first region, and a vertical projection, on the substrate, of the first regrowth layer does not overlap a vertical projection, on the substrate, of the gate, so that impact of the first regrowth layer on a breakdown voltage of the semiconductor switching device can be alleviated. In addition, the second regrowth layer is disposed in the second region, and the second regrowth layer is connected to the first regrowth layer, so that a thickness of a side, facing the second region, of the first regrowth layer is uniform.

In an optional implementation, the semiconductor switching device includes two adjacent transistors, and the two adjacent transistors are connected in parallel. In this way, a length of a gate of each transistor does not need to be excessively long, so that a size of the entire semiconductor switching device in a length direction of the gate can be reduced. In addition, the plurality of transistors connected in parallel may reduce a resistance of the semiconductor switching device. In addition, the first regrowth layer includes at least one first strip structure, and one first strip structure is disposed between gates of two adjacent transistors. Two ends of the first strip structure are connected to the second regrowth layer in the extension direction of the gate. In this way, the first strip structure may be disposed on one side of the gate G, to avoid overlapping the gate G and reducing the breakdown voltage of the semiconductor switching device. In addition, when there are a plurality of strip-shaped gates in the first region, the first strip structure and the strip-shaped gate may be alternately disposed, so that a plurality of first strip structures are distributed in a specific rule. This helps simplify a manufacturing process.

In an optional implementation, the first regrowth layer includes a plurality of first strip structures that are disposed in parallel, and an extension direction of the first strip structure is the same as the extension direction of the gate. In this way, the gate and the first strip structure may be disposed in parallel, so that distribution of the plurality of first strip structures has a specific rule, and this helps simplify the manufacturing process.

In an optional implementation, the second regrowth layer is of an annular structure, and the second regrowth layer is disposed around a periphery of the first regrowth layer. In this case, the plurality of first strip structures may be all disposed in a hollow region of the second regrowth layer, so that two ends of the first strip structure can be both connected to the second regrowth layer. Similarly, in this way, the second regrowth layer can consume gas precursors, facing two ends of the second region, of the first strip structure, so that thicknesses at the two ends of the first strip structure are consistent with or approximately consistent with a thickness at a central position of the first strip structure.

In an optional implementation, a line width of the second regrowth layer is from 10 µm to 1000 µm. In this way, an amount of gas precursors consumed when the second regrowth layer is formed in the second region may be equivalent to an amount of gas precursors consumed when the first regrowth layer is formed in the first region, so that a thickness at an edge position of the first regrowth layer may be equivalent to a thickness at a central position of the first regrowth layer, and this effectively ensures uniformity of an overall thickness of the first regrowth layer.

In an optional implementation, an area of a vertical projection, on the substrate, of the second regrowth layer is the same as an area of the second region. In this way, a surface, in the second region, of the semiconductor switching device may be flat, thereby facilitating fabrication of another device, for example, a pad.

In an optional implementation, the second regrowth layer includes a solid portion and a hollow portion that penetrates through the solid portion. The solid portion includes at least two sequentially nested first annular structures, the hollow portion is located between two adjacent first annular structures, and the first annular structure is disposed around a periphery of the first regrowth layer. In addition, in the at least two sequentially nested first annular structures, the first annular structure located in an innermost ring is connected to the two ends of the first strip structure. In this way, a quantity of first annular structures or an area of the first annular structure, a quantity of hollow portions, and an area of the hollow portion in the second regrowth layer may be controlled, so that in a process of forming the first regrowth layer and the second regrowth layer, the first region and the second region have equivalent consumption of elements released by the gas precursors, thereby helping improve uniformity of the overall thickness of the first regrowth layer.

In an optional implementation, the second regrowth layer includes a solid portion and a hollow portion that penetrates through the solid portion. The solid portion includes a second annular structure and a second strip structure. The second annular structure is disposed around a periphery of the first regrowth layer. The second strip structure is located in a hollow region of the second annular structure, a first end of the second strip structure is connected to the second annular structure, a second end of the second strip structure is connected to the first strip structure, and the hollow portion is located between second strip structures that are respectively connected to two adjacent first strip structures. Similarly, a quantity of second strip structures or an area of the second strip structure, a quantity of hollow portions, and an area of the hollow portion in the second regrowth layer may be controlled, so that in the process of forming the first regrowth layer and the second regrowth layer, the first region and the second region have equivalent consumption of elements released by the gas precursors, to improve uniformity of the overall thickness of the first regrowth layer.

In an optional implementation, line widths of the first strip structure and the second strip structure that are connected to each other may be the same. In this way, the first strip structure and the second strip structure may be connected as an integrated structure with a uniform overall line width. Therefore, in a process of fabricating the first regrowth layer and the second regrowth layer, the first strip structure and the second strip structure that are connected as an integrated structure are formed through a same aperture region on the mask material, so that a structure of the mask material can be simplified.

In an optional implementation, a third strip structure is located in the hollow region of the second annular structure, and the second strip structure is located on a side, facing the first region, of the third strip structure. The third strip structure is disposed in parallel with the first strip structure, and the gate is deployed between the third strip structure and the first strip structure. Two ends of the third strip structure are connected to the second annular structure. The hollow portion is further located between the third strip structure and the second strip structure. Based on this, in the first region, on a side, facing the second region, of the gate located on an outermost side, the third strip structure and the hollow region are disposed, and a quantity of third strip structure or an area of the third strip structure, a quantity of hollow portions, and an area of the hollow portion are controlled, so that in the first region, consumption of a gas precursor on a side, facing the second region, of the outermost gate is equivalent to consumption of a gas precursor at a remaining position in the first region, to improve uniformity of the overall thickness of the first regrowth layer.

In an optional implementation, the solid portion further includes a fourth strip structure, the fourth strip structure is located in the hollow region of the second annular structure, the fourth strip structure is located on a side, away from the second strip structure, of the third strip structure, and two ends of the fourth strip structure are connected to the second annular structure. The hollow portion is further located between the fourth strip structure and the third strip structure. Similarly, in the first region, on the side, facing the second region, of the gate located on the outermost side, the third strip structure, the fourth strip structure, and the hollow region are disposed, and a quantity of third strip structures or an area of the third strip structure, a quantity of fourth strip structures or an area of the fourth strip structure, a quantity of hollow portions, and an area of the hollow portion are controlled, so that in the first region, consumption of a gas precursor at an edge position is equivalent to consumption of a gas precursor at a central position, to improve uniformity of the overall thickness of the first regrowth layer.

In an optional implementation, an area of a vertical projection, on the substrate, of the solid portion is the same as an area of a vertical projection, on the substrate, of the at least one first strip structure in the first regrowth layer. Similarly, in the process of forming the first regrowth layer and the second regrowth layer, the first region and the second region have equivalent consumption of elements released by the gas precursors.

In an optional implementation, a line width of the solid portion is from 10 µm to 1000 µm. A technical effect of the line width of the solid portion may be obtained in a similar way as a technical effect and a value of the line width of the second regrowth layer, and details are not described herein again.

In an optional implementation, the transistor further includes a first electrode and a second electrode, where the gate of the transistor is located between the first electrode and the second electrode, and the first electrode and the second electrode are disposed on the side, away from the substrate, of the channel layer, where the first regrowth layer is disposed close to at least one of the first electrode or the second electrode relative to the gate. In this way, the first regrowth layer can be kept away from the gate, so that the first regrowth layer is not affected by a large electric field strength at the gate, the breakdown voltage of the semiconductor switching device is not reduced, and therefore, anti-puncture performance is not affected.

In an optional implementation, a part of the first regrowth layer is located between the first electrode and the substrate, and between the second electrode and the substrate; and vertical projections, on the substrate, of the first electrode and the second electrode separately overlap the vertical projection, on the substrate, of the first regrowth layer, and the first electrode and the second electrode are in ohmic contact with the first regrowth layer. Alternatively, a via is made on the first regrowth layer and the barrier layer, so that the first electrode and the second electrode are in contact with the channel layer through different vias.

In an optional implementation, the regrowth semiconductor layer includes a compound including a nitrogen element and at least one of gallium, aluminum, or indium. In this way, a material of the regrowth semiconductor layer may be a group III nitride semiconductor material, so that the regrowth semiconductor layer may be of a stable semiconductor structure. For example, the material of the regrowth semiconductor layer may be InN, GaN, AlN, InGaN, InAlN, AlGaN, AlInGaN, or the like.

In an optional implementation, a thickness of the regrowth semiconductor layer is from 5 nm to 100 nm. When the thickness of the regrowth semiconductor layer is less than 5 nm, a high requirement is imposed on manufacturing precision of the semiconductor switching device, which is not conducive to simplifying a manufacturing process and reducing production costs. In addition, when the thickness of the regrowth semiconductor layer is greater than 100 nm, the thickness of the regrowth semiconductor layer is excessively thick, and this causes a surface of a film layer subsequently fabricated on the regrowth semiconductor layer to be non-uniform, and further causes an increase in the overall thickness of the semiconductor switching device, which is not conducive to ultra-thin design of the device.

In an optional implementation, the first regrowth layer includes a first part and a second part, the first part is close to the second region relative to the second part, and a thickness of the first part is 0.5 to 1.5 times a thickness of the second part. In this way, in the first regrowth layer of the first region, the thickness of the first part located at the edge of the first region may be equivalent to the thickness of the second part located at the central position of the first region, to improve thickness uniformity of the first regrowth layer in the first region.

In an optional implementation, the transistor includes a gate semiconductor layer, the gate semiconductor layer is located between the gate and the barrier layer, and is in direct contact with the gate and the barrier layer, and the gate semiconductor layer is a P-type semiconductor layer. The gate semiconductor layer can adjust a semiconductor energy band, so that there is no two-dimensional electron gas below the gate. In this case, the semiconductor switching device is a normally-off semiconductor switching device. The first electrode of the transistor is a source, and the second electrode is a drain; or the first electrode is a drain, and the second electrode is a source. Based on this, when a gate-source voltage is greater than zero, a two-dimensional electron gas is formed at the interface between the barrier layer (including AlGaN) and the channel layer (including GaN) below the P-type semiconductor layer, a conductive channel is formed between the first electrode and the second electrode of the transistor, and the semiconductor switching device is turned on.

In an optional implementation, the gate of the transistor is in direct contact with the barrier layer. The semiconductor switching device is a normally-on semiconductor switching device.

In an optional implementation, the semiconductor switching device further includes a first dielectric layer, where the first dielectric layer is located in the first region and covers the barrier layer, a first opening region and a second opening region are disposed on the first dielectric layer, the first regrowth layer is located in the first opening region, and the gate is in contact with the barrier layer through the second opening region. Based on this, in a process of fabricating the first dielectric layer, a coverage area of the first regrowth layer and a distance between the first regrowth layer and the gate may be adjusted by setting an opening area and a position of the first opening region as required. For example, when the breakdown voltage of the semiconductor switching device meets a design requirement, and the conduction performance of the semiconductor switching device needs to be improved, the opening area of the first opening region may be increased, to increase the coverage area of the first regrowth layer, so as to improve the conduction performance of the semiconductor switching device. Alternatively, for another example, when the conduction performance of the semiconductor switching device meets the design requirement, and the breakdown voltage of the semiconductor switching device needs to be increased, the position of the first opening region may be adjusted, so that the first opening region can be closer to the first electrode or the second electrode of the transistor. In this way, the first regrowth layer located in the first opening region can be disposed away from the gate, thereby improving the breakdown voltage of the semiconductor switching device.

According to another aspect of this application, a wafer is provided, including at least two semiconductor switching devices described above, and a scribe line of the wafer overlaps the second region of the semiconductor switching device. The wafer has a same technical effect as the semiconductor switching device provided in the foregoing embodiment, and details are not described herein again.

According to another aspect of this application, a packaging structure is provided, including a package substrate and any semiconductor switching device described above. The semiconductor switching device is disposed on the package substrate. The package substrate has a same technical effect as the semiconductor switching device provided in the foregoing embodiment, and details are not described herein again.

According to another aspect of this application, an electronic device is provided, including a circuit board and any packaging structure described above. The packaging structure is electrically connected to the circuit board. The electronic device has a same technical effect as the packaging structure provided in the foregoing embodiment, and details are not described herein again.

According to another aspect of this application, a manufacturing method of a semiconductor switching device is provided. The semiconductor switching device has a first region and a second region, and the second region is disposed around a periphery of the first region. The manufacturing method includes: forming a channel layer and a barrier layer on a substrate in sequence; next, forming a mask material on a side, away from the substrate, of the barrier layer, where an aperture region of the mask material exposes the first region and the second region; next, forming a regrowth semiconductor layer in the second region and the first region; and then, forming, on the side, away from the channel layer, of the barrier layer, at least one transistor located in the first region, where the first region is a region in which one transistor or a plurality of transistors connected in parallel are disposed, and the second region is a region in which no transistor is disposed. The manufacturing method of the semiconductor switching device has a same technical effect as the semiconductor switching device provided in the foregoing embodiment, and details are not described herein again.

### BRIEF DESCRIPTION OF DRAWINGS

FIG. 1 is a diagram of a structure of an electronic device according to an embodiment of this application;
FIG. 2 is a circuit structure diagram of a power management chip in FIG. 1;
FIG. 3 is a diagram of a structure of a wafer according to an embodiment of this application;
FIG. 4 is a diagram of a structure of a packaging structure according to an embodiment of this application;
FIG. 5 is a diagram of a structure of a semiconductor switching device according to an embodiment of this application;
FIG. 6 is a diagram of another structure of a semiconductor switching device according to an embodiment of this application;
FIG. 7 is a diagram of region division of a semiconductor switching device according to an embodiment of this application;
FIG. 8 is a diagram of another structure of a semiconductor switching device according to an embodiment of this application;
FIG. 9 is a top view obtained in a direction B in FIG. 8;
FIG. 10 is a diagram of a semiconductor switching device manufacturing process according to an embodiment of this application;
FIG. 11A and FIG. 11B each are a diagram of a structure at a position a1 in FIG. 9;
FIG. 12A and FIG. 12B each are a diagram of a structure at a position a2 in FIG. 9;
FIG. 13 is a diagram of another structure of a semiconductor switching device according to an embodiment of this application;
FIG. 14 is a top view obtained in a direction C in FIG. 13;
FIG. 15A is a diagram of another structure of a semiconductor switching device according to an embodiment of this application;
FIG. 15B is a diagram of another structure of a semiconductor switching device according to an embodiment of this application;
FIG. 15C is a diagram of another structure of a semiconductor switching device according to an embodiment of this application;
FIG. 15D is a diagram of another structure of a semiconductor switching device according to an embodiment of this application;
FIG. 16 is a diagram of another structure of a semiconductor switching device according to an embodiment of this application;
FIG. 17A is another top view obtained in a direction C in FIG. 13;
FIG. 17B is another top view obtained in a direction C in FIG. 13;
FIG. 18 is a diagram of another structure of a semiconductor switching device according to an embodiment of this application;
FIG. 19 is a cross-sectional view taken along a dashed line O1-O2 in FIG. 18; and
FIG. 20 is a diagram of another structure of a semiconductor switching device according to an embodiment of this application.

### Reference numerals:

01: electronic device; 100: PCB; 101: bus; 102: SoC; 103: second RAM; 104: communication chip; 105: power management chip; 112: AP; 122: GPU; 132: first RAM; 1051: AC-DC voltage converter; 10511: first rectifier filter; 10512: transformer; 10513: control circuit; 10514: second rectifier filter; 10515: feedback circuit; 20: semiconductor switching device; 200: wafer; 201: substrate; 2010: scribe line; 30: packaging structure; 301: package substrate; 1001: first region; 1002: second region; 202: channel layer; 203: barrier layer; 204: transistor; 205: regrowth semiconductor layer; 206: 2DEG; 207: gate semiconductor layer; 31: mask material; 31: aperture region; 32: gas precursor; 2051: first regrowth layer; 20511: first part; 20512: second part; 2052: second regrowth layer; 208: first dielectric layer; 401: first opening region; 402: second opening region; 218: third dielectric layer; 209: second dielectric layer; 210: field plate; 501: first strip structure; 502: solid portion; 5021: first annular structure; 503: hollow portion; 5022: second annular structure; 5023: second strip structure; 5024: third strip structure; and 5025: fourth strip structure.

### DESCRIPTION OF EMBODIMENTS

The following describes technical solutions in embodiments of this application with reference to accompanying drawings in embodiments of this application. It is clear that the described embodiments are merely a part rather than all of embodiments of this application. When describing a single assembly, apparatus, or system, a plurality of such assemblies, apparatuses, or systems may perform related functions. For example, one or more processors may perform function descriptions related to one processor.

The terms such as "first" and "second", below are merely for convenience of description, and are not to be construed as indicating or implying relative importance or implicitly indicating a quantity of indicated technical features. Therefore, a feature limited by "first", "second", or the like may explicitly or implicitly include one or more features. In descriptions of this application, unless otherwise stated, "a plurality of" means two or more than two.

The limitations such as "parallel", "vertical", "orthogonal", and "same" (for example, a same length and a same width) mentioned in embodiments of this application are all for a current process level, but are not absolutely strict definitions in a mathematical sense. There may be a deviation of a predetermined angle between two components that are parallel or vertical to each other. In an embodiment, a predetermined threshold may be less than or equal to a threshold of 1 mm. For example, the predetermined threshold may be 0.5 mm, or may be 0.1 mm. In an embodiment, the predetermined angle may be an angle within a range of ±10°, for example, the deviation of the predetermined angle is ±5°.

In this application, unless otherwise expressly specified and limited, the term "connection" should be understood in a broad sense. For example, "connection" may be a fixed mechanical connection, or may be a detachable mechanical connection or an integration. Alternatively, "connection" may be a direct connection, or may be an indirect connection via an intermediate medium. In addition, unless otherwise specified and limited, the term "coupling" should be understood in a broad sense. For example, "coupling" may be a direct electrical connection, for example, two components are in physical contact and electrically connected, and may also be understood that different components in a line structure are electrically connected by using a physical line that can transmit an electrical signal, such as a printed circuit board (printed circuit board, PCB) copper foil or a conducting wire, to transmit the electrical signal. Alternatively, "coupling" may be an indirect electrical connection between two components through an intermediate medium. Alternatively, "coupling" may be an electrical connection between two components in a space-free/non-contact manner. For example, the two components are electrically connected in a capacitive coupling manner, to transmit the electrical signal.

In embodiments of this application, orientation terms such as ''upper'', ''lower'', "left", and "right" may include but are not limited to definitions based on illustrated orientations in which components in the accompanying drawings are placed. It should be understood that, these directional terms may be relative concepts used for relative description and clarification, and may change accordingly depending on a change in the orientations in which the components are placed in the accompanying drawings.

In the accompanying drawings of embodiments of this application, an assembly is represented by a guide line with an arrow, a component is represented by only a guide line, and an opening region like an opening or a hole is represented a guide line with a wavy line at an end part.

An embodiment of this application provides an electronic device. The electronic device may be applied to various communication systems or communication protocols, for example, a Bluetooth (Bluetooth, BT) communication technology, a global positioning system (global positioning system, GPS) communication technology, a global system for mobile communications (global system for mobile communications, GSM) communication technology, a wireless fidelity (wireless fidelity, Wi-Fi) communication technology, a wideband code division multiple access (wideband code division multiple access, WCDMA) communication technology, long term evolution (long term evolution, LTE), a 5G communication technology, and another future communication technology. The electronic device in embodiments of this application may be a mobile phone (mobile phone), a tablet computer (pad), a notebook computer, a smart home, a smart wearable device (for example, a smartwatch, a smart band, smart glasses, a smart helmet, or a smart headset), a virtual reality (virtual reality, VR) electronic device, an augmented reality (augmented reality, AR) electronic device, or the like. Alternatively, the electronic device may be a handheld device that has a wireless communication function, a compute device or another processing device connected to a wireless modem, an in-vehicle device, an electronic device in a 5G network, an electronic device in a future evolved public land mobile network (public land mobile network, PLMN), or the like. This is not limited in embodiments of this application.

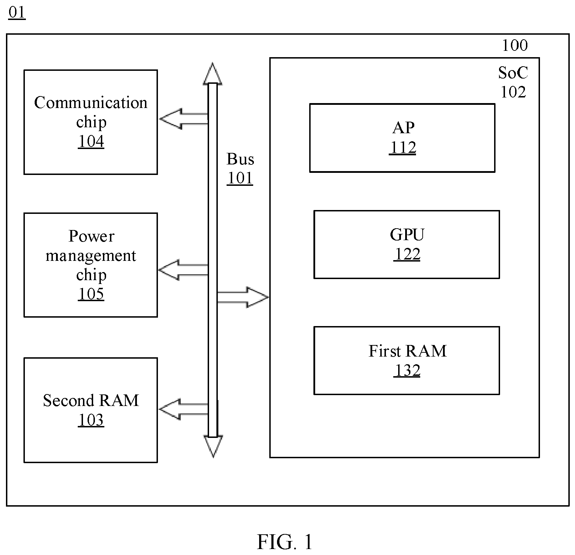

For example, as shown in FIG. 1, the electronic device 01 may include a circuit board (for example, the PCB) 100, a bus 101 disposed on the PCB 100 and electrically connected to the PCB 100, and a processor connected to the bus 101, for example, a system on chip (system on chip, SoC) 102. The SoC 102 may be configured to process data, for example, process data of an application, process image data, and cache temporary data. In an implementation, the SoC 102 may include an application processor (application processor, AP) 112 configured to process the application, a graphics processing unit (Graphics Processing Unit, GPU) 122 configured to process the image data, and a first RAM 132 configured to cache high-speed data. The first RAM 132 may be a static random access memory (static random access memory, SRAM), an embedded flash (embedded flash, eflash), or the like. The AP 112, the GPU 122, and the first RAM 132 may be integrated into one die (die), or may be separately disposed in a plurality of dies.

In addition, still as shown in FIG. 1, the electronic device 01 may further include a second RAM 103 connected to the SoC 102 through the bus 101. The second RAM 103 may be a dynamic random access memory (dynamic random access memory, DRAM). The second RAM 103 may be configured to store volatile data, for example, temporary data generated by the SoC 102. A memory capacity of the second RAM 103 may be usually greater than that of the first RAM 132, but a read speed of the second RAM 103 is usually slower than that of the first RAM 132. In addition, the electronic device 01 may further include a communication chip 104 and a power management chip 105 that are connected to the SoC 102 through the bus 101. The communication chip 104 may be configured to process a protocol stack, or perform processing such as amplification and filtering on an analog radio frequency signal, or implement the foregoing functions simultaneously. The power management chip 105 may be configured to supply power to another chip.

For example, the communication chip 104 may include a radio frequency front-end chip. The radio frequency front-end chip may include a transmit path and a receive path. The transmit path and the receive path may include a radio frequency power amplifier, a radio frequency filter, a duplexer, a radio frequency switch, a radio frequency low noise amplifier, and the like. The radio frequency power amplifier may use a semiconductor switching device, for example, a high electron mobility transistor (high electron mobility transistor, HEMT), to convert a power of a power supply into a current that changes according to an input signal, so as to perform a function of current and voltage amplification.

In addition, the power management chip 105 is an integrated circuit chip, and is configured to manage and control a power supply system. The power management chip 105 may monitor, adjust, and protect a voltage, a current, and a power of the power supply, to ensure normal running and optimal performance of the electronic device, and may further save energy and prolong a battery life. For example, the power management chip 105 may include a power switch, a power converter, a battery charger, a power monitor, an overvoltage protector, an undervoltage protector, and the like. The power supply converter may include an alternating current (alternating current, AC)-direct current (direct current, DC) voltage converter (an AC-DC voltage converter for short), a DC-DC voltage converter, a low dropout regulator (low dropout regulator, LDO), and the like. The power supply converter may include a semiconductor switching device, for example, an HEMT.

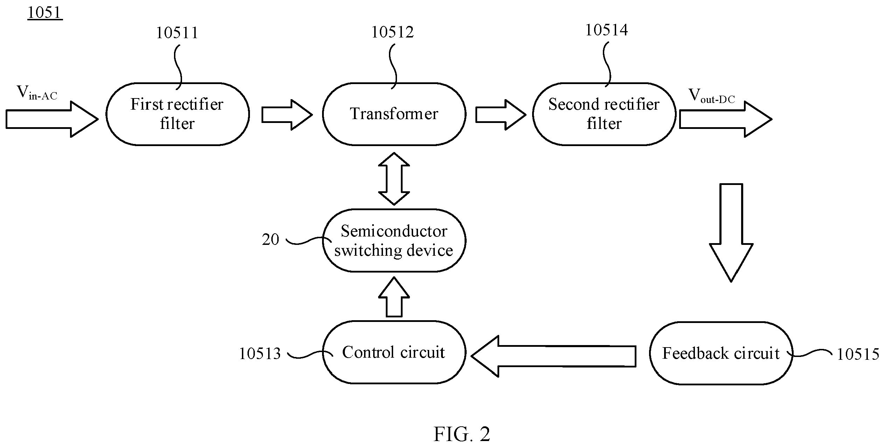

The following uses an AC-DC voltage converter as an example to describe a setting of a semiconductor switching device, for example, an HEMT, in the AC-DC voltage converter. For example, as shown in FIG. 2, the AC-DC voltage converter 1051 may include a first rectifier filter 10511, a transformer 10512, a semiconductor switching device 20, a control circuit 10513, a second rectifier filter 10514, and a feedback circuit 10515.

The first rectifier filter 10511 rectifies an input alternating current V_{in-AC} (for example, a mains 220 V) to output a voltage having a pulse waveform. The feedback circuit 10515 inputs a feedback signal to the control circuit 10513 based on an output direct current voltage V_{out-DC} (for example, 5 V). The control circuit 10513 may perform pulse width modulation (pulse width modulation, PWM) control on the semiconductor switching device 20 based on the feedback signal, to modulate a waveform of an electrical signal from the first rectifier filter 10511. The transformer 10512 may perform voltage step-down processing on the electrical signal modulated through the semiconductor switching device 20. In addition, the second rectifier filter 10514 may perform rectifier filtering on the electrical signal from the transformer 10512 to output a direct current voltage V_{out-DC} to a load (for example, a battery), thereby charging the load, for example, the battery.

The foregoing uses the AC-DC voltage converter 1051 as an example to describe a setting manner of the semiconductor switching device 20. Application of the semiconductor switching device 20 in a DC-DC voltage converter, a radio frequency power amplifier, and the like is not described herein again.

Based on this, the semiconductor switching device 20 may be independently packaged in a packaging structure, or may be packaged in a same packaging chip with another device or chip by using a packaging technology like 2.5D (dimension) packaging or 3D packaging. This is not limited in this application.

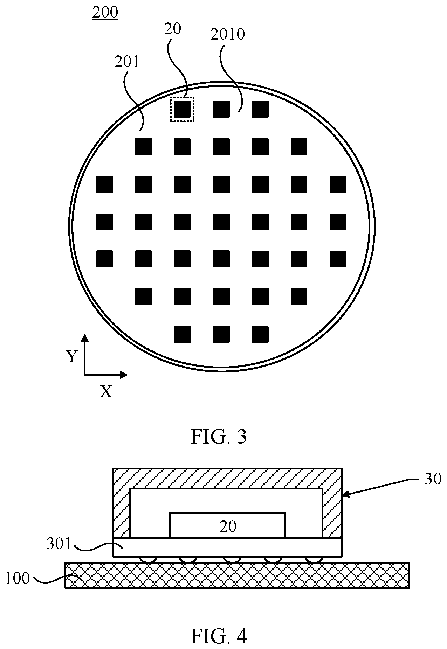

Before the semiconductor switching device 20 is packaged, an embodiment of this application may provide a wafer 200 shown in FIG. 3. The wafer 200 may include a plurality of semiconductor switching devices 20. A substrate 201 of the wafer 200 has cross-disposed scribe lines 2010, and the scribe line 2010 may separate two adjacent semiconductor switching devices 20. A plurality of semiconductor switching devices 20 used as dies (dies) may be obtained by cutting the wafer 200 along the scribe lines 2010. To facilitate describing of a structure of the semiconductor switching device 20 by using an example, the following establishes an XYZ coordinate system in the accompanying drawings. As shown in FIG. 3, an XY plane may be parallel to a surface of the substrate 201.

Next, the semiconductor switching device 20 is packaged in a packaging structure 30 shown in FIG. 4. The semiconductor switching device 20 may be disposed on a package substrate 301 of the packaging structure 30. In addition, the package substrate 301 is disposed on the circuit board 100 of the electronic device, so that the semiconductor switching device 20 can be electrically connected to the circuit board 100 through the package substrate 301.

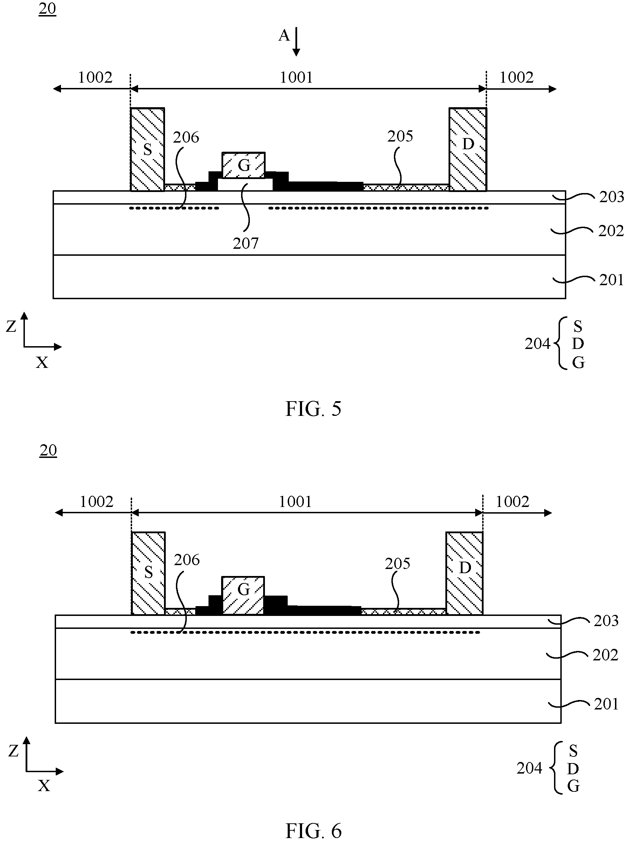

The following describes the structure of the semiconductor switching device 20 by using an example. In some embodiments of this application, as shown in FIG. 5, the semiconductor switching device 20 may include the substrate 201, a channel layer 202, a barrier layer 203, at least one transistor 204, and a regrowth semiconductor layer 205. The channel layer 202 is stacked on the substrate 201, and the barrier layer 203 is stacked on a side, away from the substrate 201, of the channel layer 202. The transistor 204 may include a gate (gate, G), a first electrode, and a second electrode. For example, the first electrode may be a source (source, S), and the second electrode may be a drain (drain, D). Alternatively, for another example, the first electrode may be a drain, and the second electrode may be a source. For ease of description, the following uses an example in which the first electrode of the transistor 204 is the S and the second electrode of the transistor 204 is the D for description. In addition, the gate G is located between the first electrode S and the second electrode G, and the first electrode S and the second electrode G are disposed on the side, away from the substrate 201, of the channel layer 202.

A direction Z shown in FIG. 5 may be a stacking direction of the substrate 201, the channel layer 202, the barrier layer 203, and the regrowth semiconductor layer 205, and a direction X may be a line width direction of the gate G, the first electrode S, and the second electrode D.

On this basis, the gate G of the transistor 204 may be disposed on a side, away from the channel layer 202, of the barrier layer 203. The regrowth semiconductor layer 205 may be disposed on the side, facing the gate G, of the barrier layer 203. Based on this, the channel layer 202, the barrier layer 203, and the regrowth semiconductor layer 205 may form an epitaxial layer of the semiconductor switching device 20. The substrate 201 may be used as a carrier of the epitaxial layer.

For example, the substrate 201 may be at least one of a silicon (Si) substrate, a sapphire (Al₂O₃) substrate, or a silicon carbide (SiC) substrate. The channel layer 202 may include a group III nitride, for example, gallium nitride (GaN). In some other embodiments of this application, the epitaxial layer of the semiconductor switching device 20 may further include a buffer layer (not shown in the figure) located between the substrate 201 and the channel layer 202. For example, a material of the buffer layer may include at least one of GaN, aluminum nitride (AlN), and aluminum gallium nitride (AlGaN). The buffer layer can reduce a probability of phenomena such as an interface mismatch, a defect, or a trap effect occurring between the substrate 201 and the channel layer 202.

In addition, for example, the channel layer 202 may include the group III nitride, for example, the gallium nitride (GaN). The barrier layer 203 may include the AlGaN. The barrier layer 203 and the channel layer 202 may form an AlGaN/GaN heterojunction. When more than two different semiconductor materials form a stacking structure, due to differences between lattice constants and band gaps of the two materials, an energy band difference exists at an interface of the two materials, and the heterojunction is formed. Based on this, in the foregoing heterojunction, due to spontaneous polarization and piezoelectric polarization effects, a discontinuous energy band structure forms a potential well at an interface (an interface between the channel layer 202 and the barrier layer 203), electrons are confined in the potential well, and consequently, the electrons essentially move in a parallel-to-interface direction and an electron movement in a vertical-to-interface direction is limited. In this way, a two dimensional electron gas (two dimensional electron gas, 2DEG) 206 may be formed at the interface. The 2DEG 206 can improve electron mobility (mobility).

Therefore, the semiconductor switching device 20 provided in this embodiment of this application may be a GaN-based HEMT device. Compared with a Si-based or silicon carbide (SiC)-based semiconductor device, the GaN-based HEMT device has higher electron mobility, electron saturation velocity, and breakdown electric field, and is more applicable to a high-frequency or high-voltage high-power application scenario, for example, a power adapter, on-board charging, or a data center.

Based on this, still as shown in FIG. 5, in a process of fabricating the semiconductor switching device 20, the channel layer 202, the buffer layer (not shown in the figure), and the barrier layer 203 may be sequentially epitaxially grown on the substrate 201 by using a metal organic chemical vapor deposition (metal organic chemical vapor deposition, MOCVD) process, a molecular beam epitaxy (molecular beam epitaxy, MBE) process, or the like. Then, the gate G, the first electrode S, and the second electrode D of the transistor 204 are formed by using a patterning process. The gate G may be in Schottky contact with the barrier layer 203, and the first electrode S and the second electrode D may be in Ohmic contact with the 2DEG 206.

For example, any one of the gate G, the first electrode S, and the second electrode D may include at least one of platinum (Pt), nickel (Ni), titanium (Ti), palladium (Pd), tantalum (Ta), tungsten (W), molybdenum (Mo), aluminum (Al), or gold (Au). Alternatively, for another example, any one of the gate G, the first electrode S, and the second electrode D may further include a metal compound like titanium nitride (TiN), tantalum nitride (TaN), or tungsten titanium (WTi). Materials of the gate G, the first electrode S, and the second electrode D may be the same or may be different. This is not limited in this application.

The patterning process refers to including an etching step, and may further include another process used to form a predetermined graph, for example, printing and inkjet.

Based on this, still as shown in FIG. 5, the semiconductor switching device 20 may further include a gate semiconductor layer 207. The gate semiconductor layer 207 may include P-type GaN, and the gate semiconductor layer 207 may be referred to as a P-type semiconductor layer. The gate semiconductor layer 207 can adjust a semiconductor energy band, so that there is no 2DEG 206 below the gate G. In this case, the semiconductor switching device 20 is a normally-off HEMT. When a gate-source voltage is greater than zero, the 2DEG 206 is formed at the interface between the channel layer 202 (including the GaN) and the barrier layer 203 (including the AlGaN) below the P-type semiconductor layer (that is, the gate semiconductor layer 207), a conductive channel is formed between the first electrode S and the second electrode D, and the semiconductor switching device 20 is turned on.

Alternatively, in some other embodiments of this application, as shown in FIG. 6, the gate G of the transistor 204 may be stacked on a surface of the barrier layer 203. In this case, a conductive channel is formed between the first electrode S and the second electrode D of the 2DEG 206, and the semiconductor switching device 20 is a normally-on HEMT. When the gate-source voltage is less than zero, the conductive channel between the first electrode S and the second electrode D is cut off, and the semiconductor switching device 20 is turned off.

On this basis, the semiconductor switching device 20 shown in FIG. 5 or FIG. 6 may have a second region 1002 and a first region 1001. For example, the second region 1002 may be a passive region (passive area), and the first region 1001 may be an active region (active area). The first region 1001 (that is, the active region) may be a region in which one transistor 204 or a plurality of transistors 204 connected in parallel are disposed in the semiconductor switching device 20.

In this case, the active region may be an effective region when the transistor 204 is turned on, that is, a region in which the 2DEG 206 formed in the semiconductor switching device 20 is located. In FIG. 6, an example in which one transistor 204 is disposed in the first region 1001 is used for description. In this case, when the transistor 204 is turned on, a region in which the 2DEG 206 formed in the semiconductor switching device 20 is located is the first region 1001.

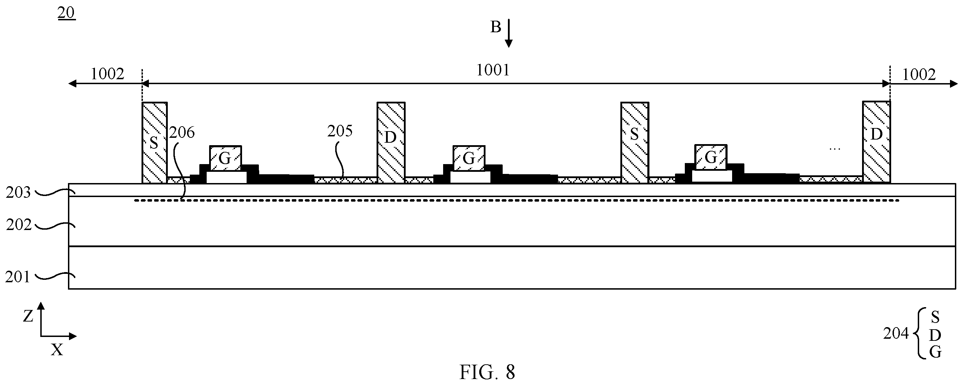

Alternatively, in some other embodiments of this application, as shown in FIG. 8, the plurality of transistors 204 may be disposed in the first region 1001, and the plurality of transistors 204 may be connected in parallel (that is, adjacent transistors 204 may share the first electrode S or the second electrode D). In this case, when the plurality of transistors 204 connected in parallel are turned on, 2DEGs 206 including the transistors 204 may be connected to each other. Therefore, a region in which the 2DEGs 206 that are connected to each other in the semiconductor switching device 20 are located may be the first region 1001.

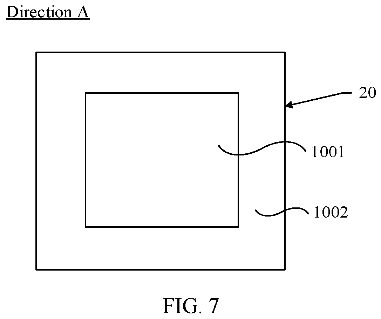

In addition, the second region 1002 (that is, the passive region) is a region, in the semiconductor switching device 20, other than the first region 1001. Therefore, the second region 1002 may be a region in which no transistor 204 is disposed. As shown in FIG. 7 (a top view obtained in a direction A in FIG. 5), the second region 1002 may be disposed around the first region 1001. In FIG. 7, an example in which the second region 1002 is disposed around a periphery of the first region 1001 is used for description. In some other embodiments of this application, the second region 1002 may not need to be disposed around a periphery of the first region 1001.

For example, the semiconductor switching device 20 in FIG. 3 may include a device region (a black part) and a non-device region (a white part) disposed around the device region. The non-device region (the white part) may partially overlap the scribe line 2010. The non-device region (the white part) may be the second region 1002 of the semiconductor switching device 20 in FIG. 7. In addition, the semiconductor switching device 20 may further include a pad (pad), and the pad may be disposed in the non-device region (the white part) of the semiconductor switching device 20.

Alternatively, for another example, the second region 1002 of the semiconductor switching device 20 may further be disposed in the device region (the black part) of the semiconductor switching device 20 in FIG. 3. The device region (the black part) may be a region having a semiconductor device, for example, the transistor 204. A quantity of second regions 1002 and a quantity of first regions 1001 in the semiconductor switching device 20 are not limited in this application.

For example, when the device region (the black part) in FIG. 3 has one transistor 204, the semiconductor switching device 20 may have one first region 1001 (that is, an active region), and one transistor 204 is disposed in the first region 1001. Alternatively, when the device region (black part) in FIG. 3 has a plurality of transistors 204 connected in parallel, the semiconductor switching device 20 may have one first region 1001 (that is, an active region), and the plurality of transistors 204 connected in parallel are disposed in the first region 1001.

Alternatively, when the device region (the black part) in FIG. 3 has a plurality of transistors 204 that are not connected in parallel and are independent of each other, the semiconductor switching device 20 may have a plurality of first regions 1001, one transistor 204 may be disposed in each first region 1001, and adjacent first regions 1001 may be separated by using the second region 1002 (that is, a passive region). Alternatively, when the device region (the black part) in FIG. 3 has a plurality of transistors 204 connected in parallel, and has an independent transistor that is not connected in parallel to the plurality of transistors, the semiconductor switching device 20 may have two first regions 1001 (that is, active regions). The plurality of transistors 204 connected in parallel are disposed in one first region 1001, and the independent transistor is disposed in the other first region 1001. The two first regions 1001 may be separated by using the second region 1002 (that is, a passive region).

For ease of description, the following uses an example in which the normally-off HEMT shown in FIG. 5 is used and the plurality of transistors 204 connected in parallel are disposed in the first region 1001 for description. In FIG. 7, an example in which shapes of the first region 1001 and the second region 1002 are rectangular is used for description. This does not constitute a limitation on the shapes of the first region 1001 and the second region 1002. The shapes of the first region 1001 and the second region 1002 may alternatively be circular, polygonal, or the like.

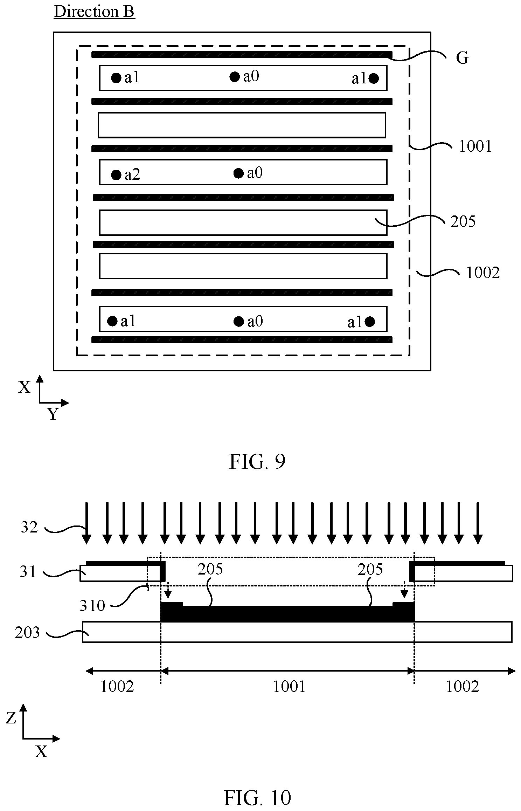

In this case, as shown in FIG. 9 (a top view obtained in a direction B in FIG. 8), gates G of the plurality of transistors 204 connected in parallel may be disposed in the first region 1001, and the gates G are strip-shaped. A direction Y may be an extension direction of the gate G.

Based on this, in comparison with a solution in which only one transistor is disposed in the semiconductor switching device, in this solution, because the plurality of transistors 204 are connected in parallel, a length, in the direction Y, of the gate G of each transistor 204 does not need to be excessively long, so that a size of the entire semiconductor switching device 20 in the direction Y can be reduced. In addition, the plurality of transistors 204 connected in parallel may reduce a resistance of the semiconductor switching device 20.

On this basis, it can be learned from the foregoing that the semiconductor switching device 20 may further include the regrowth semiconductor layer 205 shown in FIG. 8. The regrowth semiconductor layer 205 may be disposed on the side, facing the gate G of the transistor 204, of the barrier layer 203, and a band gap of the regrowth semiconductor layer 205 is greater than a band gap of the channel layer 202. In addition, the regrowth semiconductor layer 205 may be disposed in the first region 1001.

In this case, still as shown in FIG. 8, in the first region 1001, the regrowth semiconductor layer 205 is disposed on the side, facing the gate G of the transistor 204, of the barrier layer 203, and the band gap of the regrowth semiconductor layer 205 is greater than the band gap of the channel layer 202. Therefore, the regrowth semiconductor layer 205 may enhance the polarization effect in the heterojunction formed between the barrier layer 203 and the channel layer 202, so that a concentration of the 2DEG 206 can be increased. In this way, a current of the semiconductor switching device 20 may be increased and an on resistance per unit area (Ron) of the semiconductor switching device 20 may be reduced, thereby improving conduction performance of the semiconductor switching device 20. The concentration of the 2DEG 206 refers to a surface density of the 2DEG. When other performance (for example, electron mobility) of the semiconductor switching device 20 remains unchanged, a larger concentration of the 2DEG indicates a larger current of the semiconductor switching device 20.

In addition, in a case in which the overall on resistance of the semiconductor switching device 20 remains unchanged to meet a breakdown voltage design requirement, an area of the semiconductor switching device 20 may be reduced by reducing the on resistance per unit area of the semiconductor switching device 20, thereby helping improve integration of the electronic device. In this way, the semiconductor switching device 20 can be small in size while having a high breakdown voltage and good conduction performance.

In addition, while the regrowth semiconductor layer 205 in the first region 1001 improves the conduction performance of the semiconductor switching device 20, anti-breakdown performance of the semiconductor switching device 20 is reduced (for example, the breakdown voltage is reduced). Based on this, when the semiconductor switching device 20 is in a turn-off state, because an electric field strength near the gate G is large, in the first region 1001, to alleviate impact of the regrowth semiconductor layer 205 on the breakdown voltage of the semiconductor switching device 20, for example, as shown in FIG. 9, a vertical projection, on the substrate 201 (as shown in FIG. 8), of the regrowth semiconductor layer 205 may not overlap a vertical projection, on the substrate 201, of the gate G of the transistor 204.

For example, the regrowth semiconductor layer 205 may include a compound including nitrogen (N) and at least one of gallium (Ga), aluminum (Al), or indium (In). In this way, a material of the regrowth semiconductor layer 205 may be a group III nitride semiconductor material, so that the regrowth semiconductor layer 205 may be of a stable semiconductor structure. For example, the material of the regrowth semiconductor layer 205 may be InN, GaN, AlN, InGaN, InAlN, AlGaN, AlInGaN, or the like. A band gap of the group III nitride semiconductor material may be from 0.63 eV of InN to 3.40 eV of GaN and then to 6.28 eV of AlN.

Based on this, it can be learned from the foregoing that the foregoing MOCVD process may be used. As shown in FIG. 10, the regrowth semiconductor layer 205 is formed on the barrier layer 203 in the first region 1001. In a process of performing the MOCVD process, a mask material 31 needs to be disposed above the barrier layer 203. A gas precursor 32 releases an element along an arrow, and the element falls into the surface of the barrier layer 203 through an aperture region 310 of the mask material 31 and reacts, to form a crystal structure, and finally form the regrowth semiconductor layer 205.

However, still as shown in FIG. 10, some elements released by the gas precursor 32 are not consumed, and therefore fall into a non-aperture part of the mask material 31. On a periphery of the aperture region of the mask material 31, the unconsumed element attached to the mask material 31 is migrated to the surface of the barrier layer 203 along a dashed line arrow in the figure, so that a thickness of the regrowth semiconductor layer 205 in the first region 1001 is non-uniform, affecting performance of the semiconductor switching device 20.

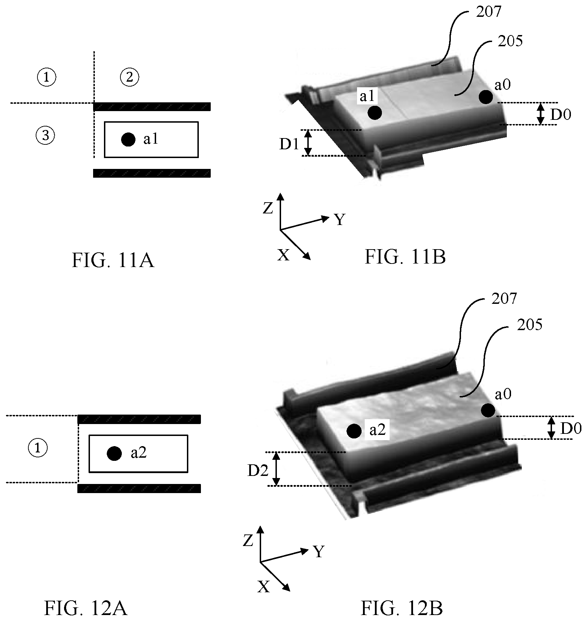

For example, in FIG. 9, positions a1 of the first region 1001 are located at positions of four corners of the first region 1001, and the position is a boundary position of the first region 1001 and the second region 1002. Specifically, as shown in FIG. 11A, there are three regions around the position a1: a region ①, a region ②, and a region ③, all of which are located in the second region 1002 (as shown in FIG. 9). Therefore, in a process of fabricating the regrowth semiconductor layer 205 in the first region 1001, all elements deposited on the mask material 31 (as shown in FIG. 10) in the region ①, the region ②, and the region ③ are migrated to the position a1 in the regrowth semiconductor layer 205.

Based on this, as shown in FIG. 11B, a thickness D1 at the position a1 in the regrowth semiconductor layer 205 is greater than a thickness D0 at the position a0 near a central position, shown in FIG. 9, in the regrowth semiconductor layer 205. For example, as shown in Table 1, D1 may be 2.5 to 3.5 times D0. On two sides of the regrowth semiconductor layer 205 shown in FIG. 11B, there is the gate semiconductor layer 207 under the gate G of the transistor. Because the gate G is strip-shaped, the gate semiconductor layer 207 is also strip-shaped.

In addition, as shown in FIG. 9, a position a2 of the first region 1001 is located at an edge of the first region 1001 and is not a four-corner position, and the position is also a boundary position of the first region 1001 and the second region 1002. Specifically, as shown in FIG. 12A, there is a region around the position a2, that is, a region ① is located in the second region 1002 (as shown in FIG. 9). Therefore, in a process of fabricating the regrowth semiconductor layer 205 in the first region 1001, the element deposited on the mask material 31 (as shown in FIG. 10) in the region ① is migrated to the position a1 in the regrowth semiconductor layer 205. Based on this, as shown in FIG. 12B, a thickness D2 at the position a2 in the regrowth semiconductor layer 205 is greater than a thickness D0 at the position a0 near a central position, shown in FIG. 9, in the regrowth semiconductor layer 205. For example, as shown in Table 1, D2 may be 2 to 3 times D0.

**Table 1**

| | a0 | a1 | a2 |
|---|---|---|---|
| Thickness of the regrowth semiconductor layer | D0 | 2.5 to 3.5 times D0 | 2 to 3 times D0 |

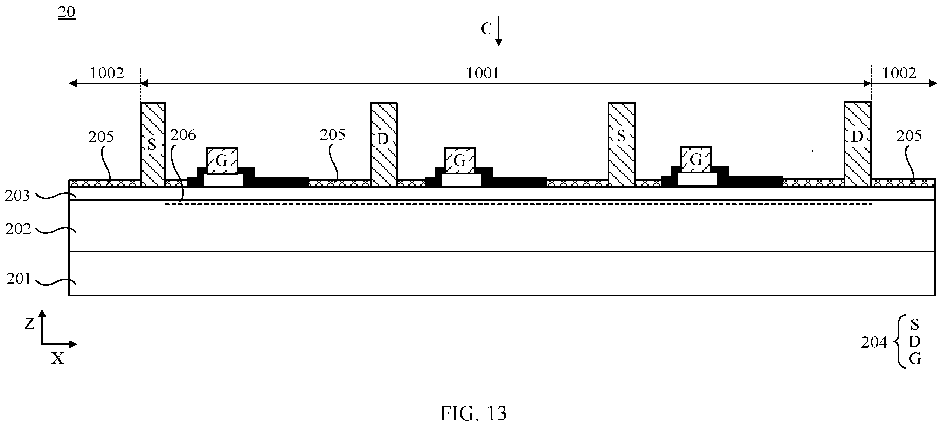

In this case, to make the regrowth semiconductor layer 205 in the first region 1001 have a uniform overall thickness, as shown in FIG. 13, in the semiconductor switching device 20 provided in this embodiment of this application, the regrowth semiconductor layer 205 may further be located in the second region 1002. In this way, the MOCVD process may be used on the barrier layer 203, so that a part, falling into the first region 1001, of the elements released by the gas precursor 32 (as shown in FIG. 10) may form a part, located in the first region 1001, of the regrowth semiconductor layer 205, and a part, falling into the second region 1002, of the elements, may form a part, located in the second region 1002, of the regrowth semiconductor layer 205, to balance supply of the gas precursor in a thin film growth process, so as to achieve a uniform material growth thickness and material composition ratio. In this way, a probability that the unconsumed element falls into the position a1 and the position a2 (as shown in FIG. 9) of the first region 1001 can be reduced, thereby improving uniformity of the thickness of the regrowth semiconductor layer 205 in the first region 1001.

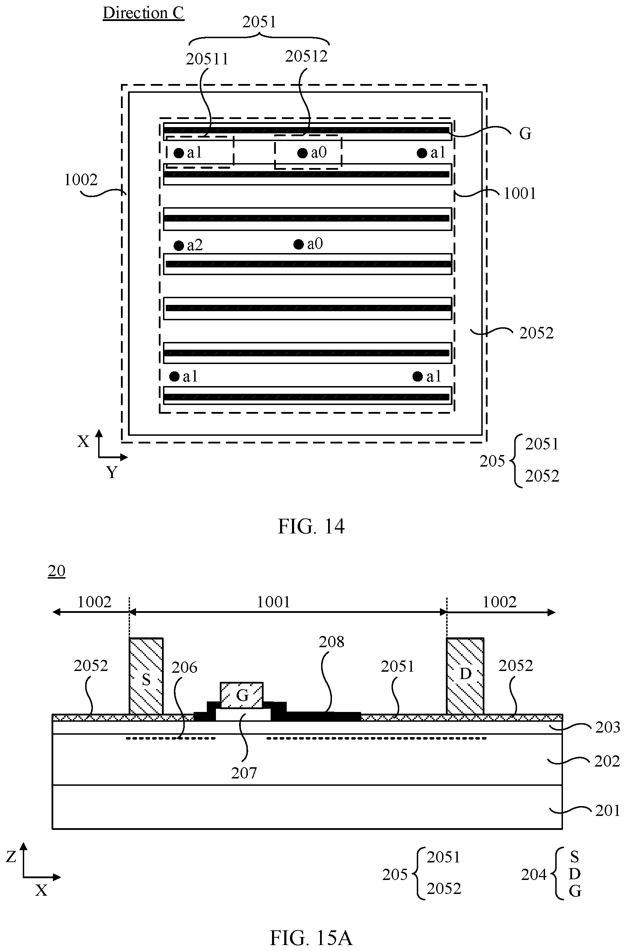

For example, when the regrowth semiconductor layer 205 is disposed in both the first region 1001 and the second region 1002 of the semiconductor switching device 20, a thickness D1 at a position a1 and a thickness D2 at a position a2 shown in FIG. 14 (a top view obtained in a direction C of FIG. 13) are shown in Table 2. Specifically, it can be learned from the foregoing that, as shown in FIG. 11A, the region ①, the region ②, and the region ③ around the position a1 are all located in the second region 1002 (as shown in FIG. 14). Therefore, in a process of fabricating the regrowth semiconductor layer 205 in the first region 1001 and the second region 1002, the region ①, the region ②, and the region ③ all consume elements provided by the gas precursor, so that the thickness D1 at the position a1 in the regrowth semiconductor layer 205 is less than the thickness D0 at the position a0 near the central position, shown in FIG. 14, in the regrowth semiconductor layer 205. For example, as shown in Table 2, D1 may be 0.5 to 1.5 times D0.

Similarly, when the regrowth semiconductor layer 205 is disposed in both the first region 1001 and the second region 1002 of the semiconductor switching device 20, there is a region around the position a2 of the first region 1001 in FIG. 14, that is, the region ① is located in the second region 1002 (as shown in FIG. 14). Therefore, in the process of fabricating the regrowth semiconductor layer 205 in the first region 1001 and the second region 1002, the region ① consumes elements provided by the gas precursor, so that the thickness D2 at the position a2 in the regrowth semiconductor layer 205 is less than the thickness D0 at the position a0 near the central position, shown in FIG. 14, in the regrowth semiconductor layer 205. For example, as shown in Table 2, D2 may be 0.5 to 1.5 times D0.

**Table 2**

| | a0 | a1 | a2 |
|---|---|---|---|
| Thickness of the regrowth semiconductor layer | D0 | 0.5 to 1.5 times D0 | 0.5 to 1.5 times D0 |

It can be learned from the foregoing that the regrowth semiconductor layer 205 is located in the first region 1001 and the second region 1002 of the semiconductor switching device 20. Based on this, as shown in FIG. 14, the regrowth semiconductor layer 205 may include a first regrowth layer 2051 located in the first region 1001 and a second regrowth layer 2052 located in the second region 1002. The first regrowth layer 2051 includes a first part 20511 and a second part 20512. The first part 20511 is close to the second region 1002 relative to the second part 20512. Therefore, the central position a0 of the first region 1001 may be a position at which the second part 20512 is located, and the position a1 (or a2) at the edge of the first region 1001 may be a position at which the first part 20511 is located. Because the thickness at the position a1 (or a2) is 0.5 to 1.5 times the thickness at the central position a0, a thickness of the first part 20511 may be 0.5 to 1.5 times a thickness of the second part 20512. In this way, in the first regrowth layer 2051 of the first region 1001, the thickness of the first part 20511 located at the edge of the first region 1001 may be equivalent to the thickness of the second part 20512 located at the central position of the first region 1001, to improve thickness uniformity of the first regrowth layer 2051 in the first region 1001.

On this basis, the thickness (a size in a direction Z in FIG. 13) of the regrowth semiconductor layer 205 may be from 5 nm to 100 nm. When the thickness of the regrowth semiconductor layer 205 is less than 5 nm, a high requirement is imposed on manufacturing precision of the semiconductor switching device 20, which is not conducive to simplifying a manufacturing process and reducing production costs. In addition, when the thickness of the regrowth semiconductor layer 205 is greater than 100 nm, the thickness of the regrowth semiconductor layer 205 is excessively thick, and this causes a surface of a film layer subsequently fabricated on the regrowth semiconductor layer 205 to be non-uniform, and further causes an increase in the overall thickness of the semiconductor switching device 20, which is not conducive to ultra-thin design of the device. For example, the thickness of the regrowth semiconductor layer 205 may be 5 nm, 10 nm, 20 nm, 30 nm, 40 nm, 50 nm, 60 nm, 70 nm, 80 nm, 90 nm, 100 nm, or the like.

In addition, the foregoing is described by using an example in which the semiconductor switching device 20 includes one regrowth semiconductor layer 205. In some other embodiments of this application, the semiconductor switching device 20 may further include a plurality of regrowth semiconductor layers 205. Different regrowth semiconductor layers 205 may include different elements, or different regrowth semiconductor layers 205 include same elements but different proportions of the elements. This is not limited in this application.

To make a thickness of a side, facing the second region 1002, of the first regrowth layer 2051 shown in FIG. 15A uniform, the first regrowth layer 2051 is connected to the second regrowth layer 2052, so that the second regrowth layer 2052 can consume a gas precursor at an edge position, facing the second region 1002, of the first regrowth layer 2051. In this way, a thickness at the edge position of the first regrowth layer 2051 is consistent with or approximately consistent with a thickness at a central position of the first regrowth layer 2051, so that the thickness of the first regrowth layer 2051 is uniform.

Based on this, in some embodiments of this application, still as shown in FIG. 15A, it can be learned from the foregoing that, to alleviate impact of the regrowth semiconductor layer 205 on the breakdown voltage of the semiconductor switching device 20, the vertical projection, on the substrate 201, of the regrowth semiconductor layer 205 does not overlap the vertical projection, on the substrate 201, of the gate G of the transistor 204. Therefore, the vertical projection, on the substrate 201, of the first regrowth layer 2051 does not overlap the vertical projection, on the substrate 201, of the gate G.

On this basis, still as shown in FIG. 15A, to further reduce the impact of the first regrowth layer 2051 on the breakdown voltage of the semiconductor switching device 20, relative to the gate G, the first regrowth layer 2051 may be disposed close to at least one of the first electrode S or the second electrode D of the transistor 204. In this way, the first regrowth layer 2051 can be kept away from the gate G, so that the first regrowth layer 2051 is not affected by a large electric field strength at the gate G, the breakdown voltage of the semiconductor switching device 20 is not reduced, and therefore, anti-puncture performance is not affected.

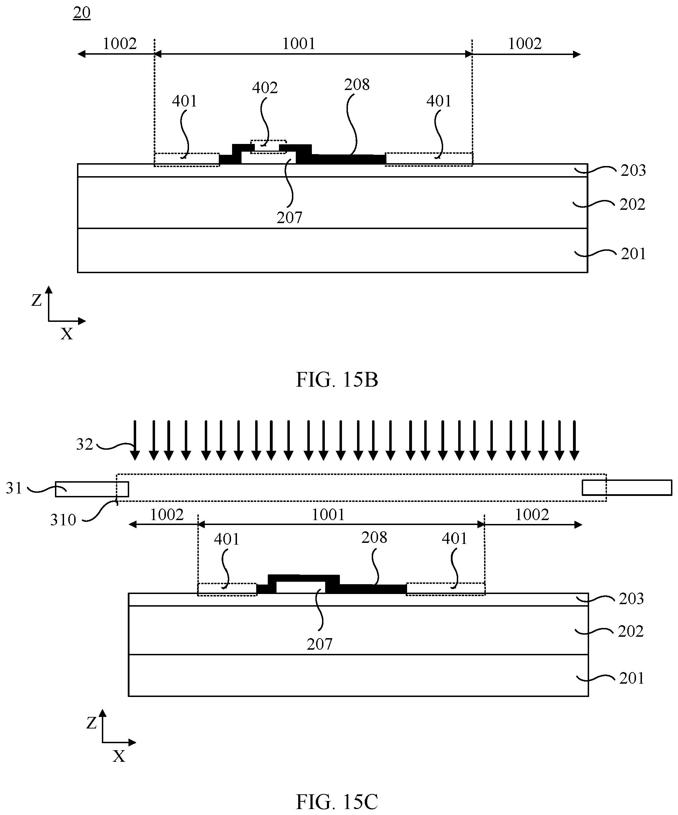

Based on this, to enable the first regrowth layer 2051 to be disposed close to the at least one of the first electrode S or the second electrode D of the transistor 204, a first dielectric layer 208 shown in FIG. 15A is used. The first dielectric layer 208 may be located in the first region 1001, and the first dielectric layer 208 covers the barrier layer 203. In addition, as shown in FIG. 15B, a first opening region 401 and a second opening region 402 are disposed on the first dielectric layer 208, the first regrowth layer 2051 (shown in FIG. 15A) is located in the first opening region 401, and the gate G (shown in FIG. 15A) passes through the second opening region 402. When the semiconductor switching device 20 includes the gate semiconductor layer 207, the gate G located in the second opening region 402 may be in contact with the gate semiconductor layer 207.

For example, the first dielectric layer 208 may include at least one of silicon nitride (SiN), silicon oxide (SiO₂), aluminum oxide (Al₂O₃), aluminum nitride (AlN), or gallium oxide (Ga₂O₃).

Based on this, in a process of fabricating the first dielectric layer 208, a coverage area of the first regrowth layer 2051 and a distance between the first regrowth layer 2051 and the gate G may be adjusted by setting an opening area and a position of the first opening region 401 as required. For example, when the breakdown voltage of the semiconductor switching device 20 meets the design requirement, and the conduction performance of the semiconductor switching device 20 needs to be improved, the opening area of the first opening region 401 may be increased, to increase the coverage area of the first regrowth layer 2051, so as to improve the conduction performance of the semiconductor switching device 20.

Alternatively, for another example, when the conduction performance of the semiconductor switching device 20 meets the design requirement, and the breakdown voltage of the semiconductor switching device 20 needs to be increased, the position of the first opening region 401 may be adjusted, so that the first opening region 401 can be closer to the first electrode D or the second electrode S of the transistor 204. In this way, the first regrowth layer 2051 located in the first opening region 401 can be disposed away from the gate G, thereby improving the breakdown voltage of the semiconductor switching device 20.

Based on this, a manufacturing method of the semiconductor switching device 20 may include: First, the channel layer 202, the barrier layer 203, and the gate semiconductor layer 207 located on the side, away from the substrate 201, of the barrier layer 203 are sequentially formed on the substrate 201 shown in FIG. 15C. Next, a dielectric material layer covering the gate semiconductor layer 207 and the barrier layer 203 is formed. The dielectric material layer may include at least one of SiN, SiO₂, Al₂O₃, AlN, or Ga₂O₃. Then, a part of the dielectric layer material may be removed by using an etching process, to form the first dielectric layer 208 having the first opening region 401 and the second opening region 402, where the first opening region 401 and the second opening region 402 may be formed by using the etching process twice.

For example, the first opening region 401 shown in FIG. 15C may be first formed by using the etching process, and then the mask material 31 is formed on the side, away from the substrate 201, of the barrier layer 203. The first region 1001 and the second region 1002 are exposed in the aperture region 310 of the mask material 31. Next, the mask material 31 is used as a mask, and the MOCVD process is used, so that elements released by the gas precursor 32 fall into the first region 1001 and the second region 1002, to form the regrowth semiconductor layer 205 (as shown in FIG. 15A) in the first region 1001 and the second region 1002.

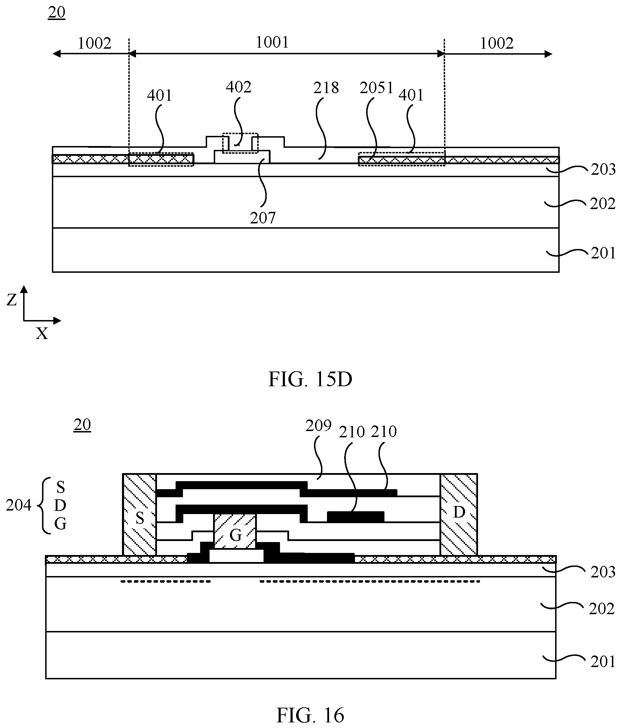

Then, the first dielectric layer 208 shown in FIG. 15C may be removed, and a third dielectric layer 218 shown in FIG. 15D is formed. The third dielectric layer 218 may cover a regrowth layer (including the first regrowth layer 2051). Then, the second opening region 402 is formed on the third dielectric layer 218 by using the etching process. Next, the gate G shown in FIG. 15A is formed in the second opening region 402. Then, the first electrode S and the second electrode D of the transistor 204 are formed, to form, on the side, away from the channel layer 202, of the barrier layer 203, at least one transistor 204 located in the first region 1001. Alternatively, for another example, after the first regrowth layer 2051 is formed in the first opening region 401, the first dielectric layer 208 may be retained, and then the second opening region 402 shown in FIG. 15B is formed on the first dielectric layer 208. Next, the gate G of the transistor 204 is formed as described above, and then the first electrode S and the second electrode D are formed.

For example, vertical projections, on the substrate 201, of the first electrode S and the second electrode D separately overlap the vertical projection, on the substrate 201, of the first regrowth layer 2051. The first electrode S and the first electrode D may be directly formed on a surface, away from the substrate 201, of the first regrowth layer 2051, and the first electrode S and the first electrode D are in ohmic contact with the first regrowth layer 2051 by using an annealing technology. Alternatively, for another example, a via (Via) may be formed on the first regrowth layer 2051 and the barrier layer 203, so that the first electrode S and the first electrode D are in contact with the channel layer 202 through vias. This is not limited in this application.

In addition, as shown in FIG. 16, the manufacturing method of the semiconductor switch 20 may further include: At least one second dielectric layer 209 and a field plate (field plate, FP) 210 are formed on a side, away from the substrate 201, of the gate G of the transistor 204. The second dielectric layer 209 is configured to insulate the field plate 210 from the gate G, or the second dielectric layer 209 is further configured to insulate adjacent field plates 210. The field plate 210 may be electrically connected to at least one of the gate G, the first electrode S, and the second electrode D of the transistor 204, to adjust an electric field. A quantity of field plates 210 and a manner of disposing the field plates 210 are not limited in this application. In FIG. 16, two field plates 210 are only used as an example for description.

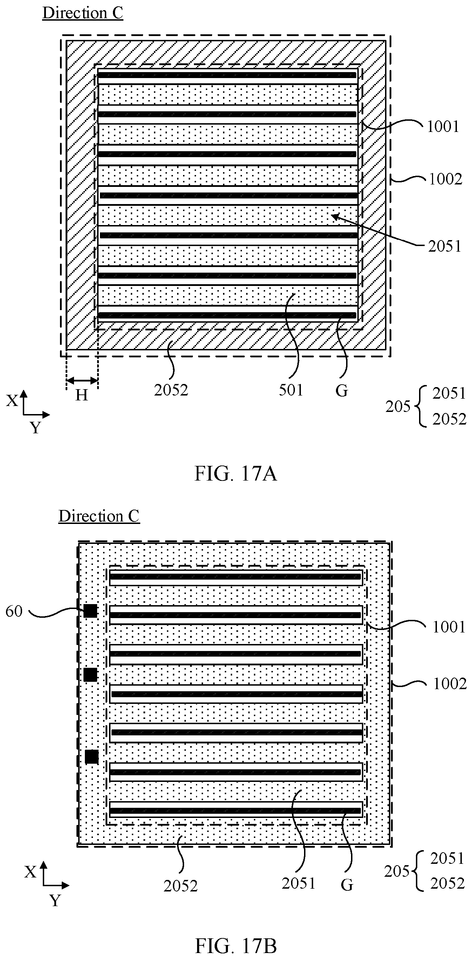

The following describes shapes of the first regrowth layer 2051 and the second regrowth layer 2052 by using examples. In some embodiments of this application, it can be learned from the foregoing that when the semiconductor switching device 20 includes a plurality of transistors 204 connected in parallel, as shown in FIG. 17A, gates G of the plurality of transistors in the first region 1001 are strip-shaped and disposed side by side. Based on this, the first regrowth layer 2051 may include at least one first strip structure 501, and one first strip structure 501 is disposed between gates G of two adjacent transistors. Two ends of the first strip structure 501 are connected to the second regrowth layer 2052 in the extension direction (that is, the direction Y) of the gate G.

In this way, the first strip structure 501 may be disposed on one side of the gate G, to avoid overlapping the gate G and reducing the breakdown voltage of the semiconductor switching device 20. In addition, when there are a plurality of strip-shaped gates G in the first region 1001, the first strip structure 501 and the strip-shaped gate G may be alternately disposed, so that a plurality of first strip structures 501 are distributed in a specific rule. This helps simplify a structure of the mask material of the MOCVD, to simplify the manufacturing process. For example, line widths of the plurality of first strip structures 501 may be the same, so that the manufacturing process can be further simplified.

In addition, still as shown in FIG. 17A, the second regrowth layer 2052 located in the second region 1002 may be annular, and the second regrowth layer 2052 may be disposed around a periphery of the first regrowth layer 2051. In this case, the plurality of first strip structures 501 may all be disposed in a hollow region of the second regrowth layer 2052, so that the two ends of the first strip structure 501 can be both connected to the second regrowth layer 2052. Similarly, in this way, the second regrowth layer 2052 can consume gas precursors, facing two ends of the second region 1002, of the first strip structure 501, so that thicknesses at the two ends of the first strip structure 501 are consistent with or approximately consistent with a thickness at a central position of the first strip structure 501.

On this basis, in some embodiments of this application, still as shown in FIG. 17A, a line width H of the second regrowth layer 2052 may be from 10 µm to 1000 µm. When the line width H of the second regrowth layer 2052 is less than 10 µm, in a process of forming the second regrowth layer 2052, consumption of elements released by the edge gas precursor of the first regrowth layer 2051 is small, and consequently, a large difference still exists between the edge thickness of the first regrowth layer 2051 and a center thickness of the first regrowth layer 2051, reducing uniformity of the thickness of the first regrowth layer 2051. In addition, when the line width H of the second regrowth layer 2052 is greater than 1000 µm, although the difference between the edge thickness of the first regrowth layer 2051 and the center thickness of the first regrowth layer 2051 can be effectively reduced, the width H of the second regrowth layer 2052 is wide, and may occupy a large space, which is not conducive to compact device layout.

Based on this, when the line width H of the second regrowth layer 2052 is within a range of 10 µm to 1000 µm, an amount of gas precursors consumed when the second regrowth layer 2052 is formed in the second region 1002 may be equivalent to an amount of gas precursors consumed when the first regrowth layer 2051 is formed in the first region 1001, so that a thickness at an edge position of the first regrowth layer 2051 may be equivalent to a thickness at a central position of the first regrowth layer 2051, and this effectively ensures uniformity of the overall thickness of the first regrowth layer 2051. For example, the line width H may be 10 µm, 20 µm, 40 µm, 60 µm, 80 µm, 100 µm, 200 µm, 400 µm, 600 µm, 800 µm, 1000 µm, or the like.

Alternatively, in some other embodiments of this application, as shown in FIG. 17B, an area of the vertical projection, on the substrate 201 (as shown in FIG. 16), of the second regrowth layer 2052 may be the same as or approximately the same as an area of the second region 1002. In this way, a surface, in the second region 1002, of the semiconductor switching device 20 may be flat, thereby facilitating fabrication of another device, for example, a pad (pad) 60. In FIG. 17B, only a position of the pad 60 is used, and a quantity of pads 60, a shape of the pad 60, and a structure of the pad 60 are not limited.

The foregoing describes the first regrowth layer 2051 and the second regrowth layer 2052 by using an example in which the first regrowth layer 2051 in the first region 1001 includes a plurality of first strip structures 501 spaced from each other, and the second regrowth layer 2052 in the second region 1002 is of an annular structure, as shown in FIG. 17A or FIG. 17B.

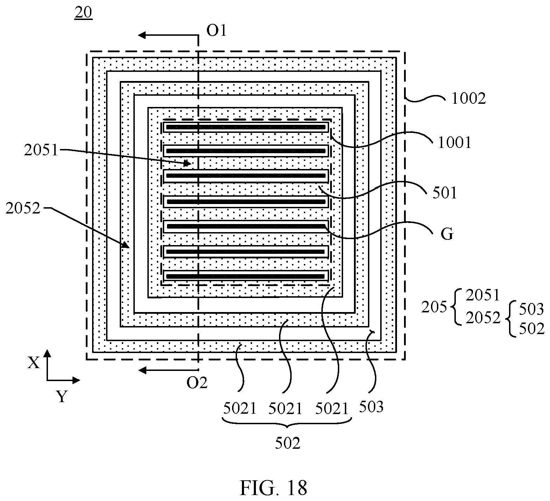

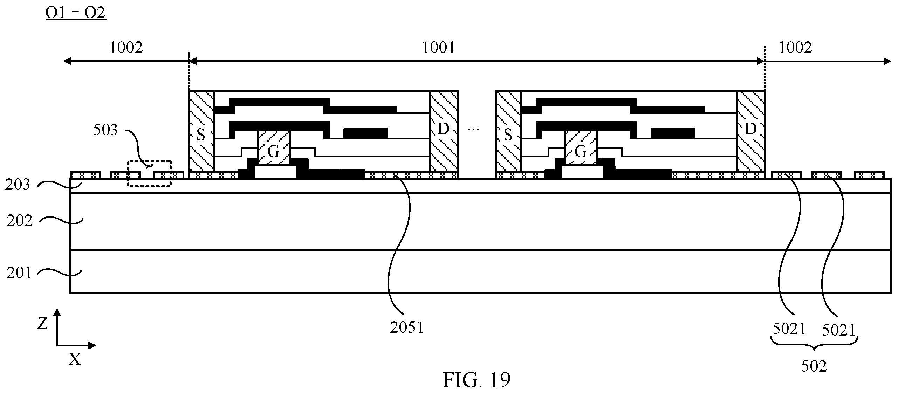

In some other embodiments of this application, as shown in FIG. 18, similarly, the first regrowth layer 2051 in the first region 1001 includes a plurality of first strip structures 501 spaced from each other. A disposing manner and a technical effect of the first strip structure 501 are the same as those described above. Details are not described herein again. A difference lies in that the second regrowth layer 2052 may include a solid portion 502 and a hollow portion 503 that penetrates through the solid portion 502. As shown in FIG. 19 (a cross-sectional view taken along a dashed line O1-O2 in FIG. 18), the hollow portion 503 is a hole structure formed by removing, by using the patterning process, a part of a material used to form a thin film layer of the second regrowth layer 2052. The hollow portion 503 may expose a film layer, for example, the barrier layer 203, facing the substrate 201, below the second regrowth layer 2052. In addition, the solid portion 502 is an unremoved part of the thin film layer used to form the second regrowth layer 2052.

Still as shown in FIG. 18, the solid portion 502 may include at least two sequentially nested first annular structures 5021, and the first annular structure 5021 is disposed around a periphery of the first regrowth layer 2051. In addition, the hollow portion 503 may be located between two adjacent first annular structures 5021. On this basis, in the at least two sequentially nested first annular structures 5021, the first annular structure 5021 located in the innermost ring may be connected to the two ends of the first strip structure 501 in the first regrowth layer 2051, so that an edge of the first strip structure 501 may be connected to the second regrowth layer 2052.

In this way, a quantity of first annular structures 5021 or an area of the first annular structure 5021, a quantity of hollow portions 503, and an area of the hollow portion 503 in the second regrowth layer 2052 may be controlled, so that in a process of forming the first regrowth layer 2051 and the second regrowth layer 2052, the first region 1001 and the second region 1002 have equivalent consumption of elements released by the gas precursors, to help improve uniformity of the overall thickness of the first regrowth layer 2051.

Based on this, to enable the first region 1001 and the second region 1002 to have equivalent consumption of elements released by the gas precursors in the process of forming the first regrowth layer 2051 and the second regrowth layer 2052, an area of a vertical projection, on the substrate 201 (as shown in FIG. 16), of the solid portion 502 (including a plurality of first annular structures 5021) shown in FIG. 18 may be the same as an area of a vertical projection, on the substrate 201, of the at least one first strip structure 501 in the first regrowth layer 2051.

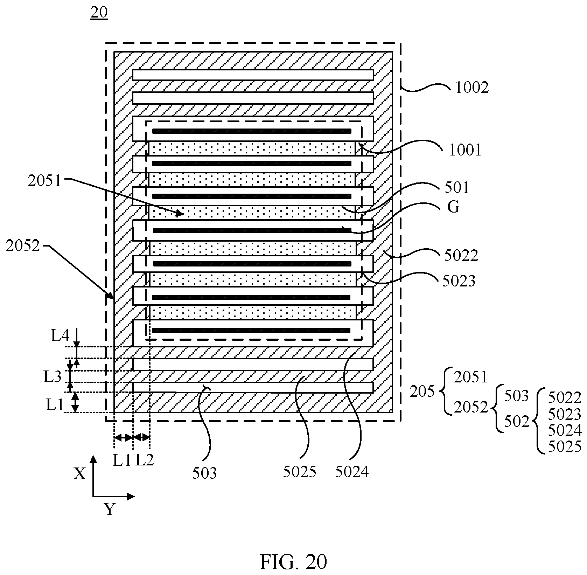

Alternatively, in some other embodiments of this application, as shown in FIG. 20, when the second regrowth layer 2052 includes the solid portion 502 and the hollow portion 503, the solid portion 502 may include a second annular structure 5022 and a second strip structure 5023. The second annular structure 5022 is disposed around a periphery of the first regrowth layer 2051. The second strip structure 5023 is located in a hollow region of the second annular structure 5022, a first end of the second strip structure 5023 is connected to the second annular structure 5022, and a second end of the second strip structure 5023 is connected to the first strip structure 501.

In this case, one second strip structure 5023 may be disposed at each of two ends of the first strip structure 501, so that the first strip structure 501 may be connected to the second annular structure 5022 through second strip structures 5023 at the two ends, and the first regrowth layer 2051 in the first region 1001 is connected to the second regrowth layer 2052 in the second region 1002.

For example, line widths of the first strip structure 501 and the second strip structure 5023 that are connected to each other may be the same. In this way, the first strip structure 501 and the second strip structure 5023 may be connected as an integrated structure with a uniform overall line width. Therefore, in the process of fabricating the first regrowth layer 2051 and the second regrowth layer 2052 through MOCVD, the first strip structure 501 and the second strip structure 5023 that are connected as an integrated structure are formed through a same aperture region on the mask material, so that a structure of the mask material can be simplified.

In addition, the hollow portion 503 may be located between second strip structures 5023 that are respectively connected to two adjacent first strip structures 501. In other words, in the direction X, the hollow portion 503 may be disposed between two adjacent second strip structures 5023. Similarly, a quantity of second strip structures 5023 or an area of the second strip structure 5023, a quantity of hollow portions 503, and an area of the hollow portion 503 in the second regrowth layer 2052 may be controlled, so that in the process of forming the first regrowth layer 2051 and the second regrowth layer 2052, the first region 1001 and the second region 1002 have equivalent consumption of elements released by the gas precursors, to improve uniformity of the overall thickness of the first regrowth layer 2051.

On this basis, still as shown in FIG. 20, the solid portion 502 may further include a third strip structure 5024, and the third strip structure 5024 is located in the hollow region of the second annular structure 5022. The second strip structure 5023 is located on a side, facing the first region 1001, of the third strip structure 5024. The third strip structure 5024 may be disposed in parallel with the first strip structure 501, and a gate G is deployed between the third strip structure 5024 and the first strip structure 501. Two ends of the third strip structure 5024 are connected to the second annular structure 5022. The hollow portion 503 is further located between the third strip structure 5024 and the second strip structure 5023.

In this case, because the third strip structure 5024 is located in the second region 1002, and the gate G is deployed between the third strip structure 5024 and the first strip structure 501, the gate G between the third strip structure 5024 and the first strip structure 501 is a gate located on the outermost side in the first region 1001.

Based on this, in the first region 1001, on a side, facing the second region 1002, of the gate G located on the outermost side, the third strip structure 5024 and the hollow portion 503 are disposed, and a quantity of third strip structure 5024 or an area of the third strip structure 5024, a quantity of hollow portions 503, and an area of the hollow portion 503 are controlled, so that in the first region 1001, consumption of a gas precursor on a side, facing the second region 1002, of the outermost gate G is equivalent to consumption of a gas precursor at a remaining position in the first region 1001, to improve uniformity of the overall thickness of the first regrowth layer 2051.

On this basis, still as shown in FIG. 20, the solid portion 502 may further include a fourth strip structure 5025, and the fourth strip structure 5025 may be located in the hollow region of the second annular structure 5022. The fourth strip structure 5025 is located on a side, away from the second strip structure 5023, of the third strip structure 5024, and two ends of the fourth strip structure 5025 are connected to the second annular structure 5022. The hollow portion 503 is further located between the fourth strip structure 5025 and the third strip structure 5024.

Similarly, in the first region 1001, on a side, facing the second region 1002, of the gate G located on the outermost side, the third strip structure 5024, the fourth strip structure 5025, and the hollow portion 503 are disposed, and a quantity of third strip structures 5024 or an area of the third strip structure 5024, a quantity of fourth strip structures 5025 or an area of the fourth strip structure 5025, a quantity of hollow portions 503, and an area of the hollow portion 503 are controlled, so that in the first region 1001, consumption of a gas precursor at an edge position is equivalent to consumption of a gas precursor at a central position, to improve uniformity of the overall thickness of the first regrowth layer 2051.

In addition, to enable the first region 1001 and the second region 1002 to have equivalent consumption of elements released by the gas precursors in the process of forming the first regrowth layer 2051 and the second regrowth layer 2052, an area of a vertical projection, on the substrate 201 (as shown in FIG. 16), of the solid portion 502 (including the second annular structure 5022, the second strip structure 5023, the third strip structure 5024, and the fourth strip structure 5025) shown in FIG. 20 may be the same as an area of a vertical projection, on the substrate 201, of the at least one first strip structure 501 in the first regrowth layer 2051.

In addition, a line width of the solid portion 502 shown in FIG. 20 may be from 10 µm to 1000 µm. For example, when the solid portion 502 includes the second annular structure 5022, the second strip structure 5023, the third strip structure 5024, and the fourth strip structure 5025, in the direction Y, a line width L1 of the solid portion 502 may be a sum H1 of a line width of the second annular structure 5022 and a length L2 of the second strip structure 5023, that is, H1=L1+L2, where H1 is from 10 µm to 1000 µm. In addition, in the direction X, a line width of the solid portion 502 may be a sum H2 of the line width L1 of the second annular structure 5022, a line width L3 of the third strip structure 5024, and a line width L4 of the fourth strip structure 5025, that is, H2=L1+L3+L4, where H2 is from 10 µm to 1000 µm.

Similarly, a technical effect and a value of the line width of the solid portion 502 that are from 10 µm to 1000 µm may be obtained in the same way as a technical effect and a value of the line width H of the second regrowth layer 2052 shown in FIG. 17A, and details are not described herein again. In addition, the foregoing is merely an example for describing a shape of the solid portion of the second regrowth layer 2052. In some other embodiments of this application, the solid portion may further include a plurality of inclined strip structures spaced from each other, or cross-disposed strip structures. Details are not described herein again in this application.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A semiconductor switching device, comprising a first region and a second region, wherein the second region is disposed around the first region, and the semiconductor switching device comprises:
a substrate;
a channel layer, disposed on the substrate;
a barrier layer, disposed on a side, away from the substrate, of the channel layer;
at least one transistor, located in the first region, wherein a gate of the transistor is disposed on a side, away from the channel layer, of the barrier layer, the first region is a region in which one transistor or a plurality of transistors connected in parallel are disposed, and the second region is a region in which no transistor is disposed; and
a regrowth semiconductor layer, located in the first region and the second region, wherein the regrowth semiconductor layer is disposed on the side, facing the gate, of the barrier layer.

2. The semiconductor switching device according to claim 1, wherein
the regrowth semiconductor layer comprises:
a first regrowth layer, disposed in the first region, wherein a vertical projection, on the substrate, of the first regrowth layer does not overlap a vertical projection, on the substrate, of the gate; and
a second regrowth layer, disposed in the second region, wherein the second regrowth layer is connected to the first regrowth layer.

3. The semiconductor switching device according to claim 2, wherein
the semiconductor switching device comprises two adjacent transistors, and the two adjacent transistors are connected in parallel; and
the first regrowth layer comprises at least one first strip structure, one first strip structure is disposed between gates of the two adjacent transistors, and two ends of the first strip structure are connected to the second regrowth layer in an extension direction of the gate.

4. The semiconductor switching device according to claim 2 or 3, wherein
the second regrowth layer is of an annular structure, and the second regrowth layer is disposed around a periphery of the first regrowth layer.

5. The semiconductor switching device according to claim 4, wherein
a line width of the second regrowth layer is from 10 µm to 1000 µm.

6. The semiconductor switching device according to claim 4 or 5, wherein
an area of a vertical projection, on the substrate, of the second regrowth layer is the same as an area of the second region.

7. The semiconductor switching device according to claim 3, wherein
the second regrowth layer comprises a solid portion and a hollow portion that penetrates the solid portion;
the solid portion comprises at least two sequentially nested first annular structures, the hollow portion is located between two adjacent first annular structures, and the first annular structure is disposed around a periphery of the first regrowth layer; and
in the at least two sequentially nested first annular structures, the first annular structure located in an innermost ring is connected to the two ends of the first strip structure.

8. The semiconductor switching device according to claim 3, wherein
the second regrowth layer comprises a solid portion and a hollow portion that penetrates the solid portion, and the solid portion comprises:
a second annular structure, disposed around a periphery of the first regrowth layer; and
a second strip structure, located in a hollow region of the second annular structure, wherein a first end of the second strip structure is connected to the second annular structure, a second end of the second strip structure is connected to the first strip structure, and the hollow portion is located between second strip structures that are respectively connected to two adjacent first strip structures.

9. The semiconductor switching device according to claim 8, wherein the first strip structure and the second strip structure that are connected to each other have a same line width.

10. The semiconductor switching device according to claim 8 or 9, wherein the solid portion further comprises:
a third strip structure, located in the hollow region of the second annular structure, wherein the second strip structure is located on a side, facing the first region, of the third strip structure; the third strip structure and the first strip structure are disposed in parallel, and the gate is deployed between the third strip structure and the first strip structure; two ends of the third strip structure are connected to the second annular structure; and the hollow portion is further located between the third strip structure and the second strip structure.

11. The semiconductor switching device according to claim 10, wherein the solid portion further comprises:
a fourth strip structure, located in the hollow region of the second annular structure, the fourth strip structure is located on a side, away from the second strip structure, of the third strip structure, and two ends of the fourth strip structure are connected to the second annular structure; and the hollow portion is further located between the fourth strip structure and the third strip structure.

12. The semiconductor switching device according to any one of claims 7 to 11, wherein
an area of a vertical projection, on the substrate, of the solid portion is the same as an area of a vertical projection, on the substrate, of the at least one first strip structure in the first regrowth layer.

13. The semiconductor switching device according to any one of claims 7 to 12, wherein
a line width of the solid portion is from 10 µm to 1000 µm.

14. The semiconductor switching device according to any one of claims 2 to 13, wherein the transistor further comprises:
a first electrode and a second electrode, wherein the gate is located between the first electrode and the second electrode, and the first electrode and the second electrode are disposed on the side, away from the substrate, of the channel layer, wherein
the first regrowth layer is disposed close to at least one of the first electrode or the second electrode relative to the gate.

15. The semiconductor switching device according to claim 14, wherein
a part of the first regrowth layer is located between the first electrode and the substrate, and between the second electrode and the substrate; and vertical projections, on the substrate, of the first electrode and the second electrode separately overlap the vertical projection, on the substrate, of the first regrowth layer, and the first electrode and the second electrode are in ohmic contact with the first regrowth layer.

16. The semiconductor switching device according to any one of claims 1 to 15, wherein the regrowth semiconductor layer comprises a compound comprising a nitrogen element and at least one of gallium, aluminum, or indium.

17. The semiconductor switching device according to any one of claims 1 to 16, wherein a thickness of the regrowth semiconductor layer is from 5 nm to 100 nm.

18. The semiconductor switching device according to any one of claims 2 to 17, wherein the first regrowth layer comprises a first part and a second part, the first part is close to the second region relative to the second part, and a thickness of the first part is 0.5 to 1.5 times a thickness of the second part.

19. A wafer, comprising at least two semiconductor switching devices according to any one of claims 1 to 18, wherein a scribe line of the wafer overlaps the second region of the semiconductor switching device.

20. A packaging structure, comprising:
a package substrate; and
the semiconductor switching device according to any one of claims 1 to 18, wherein the semiconductor switching device is disposed on the package substrate.

21. An electronic device, comprising:
a circuit board; and
the packaging structure according to claim 20, wherein the packaging structure is electrically connected to the circuit board.

22. A manufacturing method of a semiconductor switching device, wherein the semiconductor switching device has a first region and a second region, and the second region is disposed around the first region; and the manufacturing method comprises:
forming a channel layer and a barrier layer on a substrate in sequence;
forming a mask material on a side, away from the substrate, of the barrier layer, wherein an aperture region of the mask material exposes the first region and the second region;
forming a regrowth semiconductor layer in the second region and the first region; and
forming, on the side, away from the channel layer, of the barrier layer, at least one transistor located in the first region, wherein the first region is a region in which one transistor or a plurality of transistors connected in parallel are disposed, and the second region is a region in which no transistor is disposed.
